# EUROPÄISCHE PATENTSCHRIFT

(11) **EP 1 464 433 B1**
(45) Veröffentlichungstag und Bekanntmachung des Hinweises auf die Patenterteilung: **07.03.2007**
(21) Anmeldenummer: 04001476.3
(22) Anmeldetag: 23.01.2004
(51) Int. Cl.: B23K 20/00, B23K 20/10

(54) **Verfahren und Vorrichtung zur Prüfung einer Drahtbondverbindung**
Method and Aparaturs for testing a wire bond connection
Procédé et dispositif de test pour des connexions de fils

(30) Priorität: 04.04.2003 DE 10315639
(43) Veröffentlichungstag der Anmeldung: 06.10.2004
(73) Patentinhaber: Hesse & Knipps GmbH, 33100 Paderborn (DE)
(72) Erfinder: Walther, Frank, Dipl.-Ing., 33034 Brakel (DE)
(74) Vertreter: Rieder, Hans-Joachim

(56) Entgegenhaltungen:
- DE-A- 3 717 856
- DE-A- 10 349 154
- US-A- 5 894 981
- US-A1- 2002 040 921
- US-B1- 6 564 115

## Beschreibung

Die Erfindung betrifft ein Verfahren zur insbesondere zerstörungsfreien Prüfung einer Drahtbondverbindung, bei dem nach der Herstellung einer Bondverbindung mittels eines Bondwedges zwischen einem Draht und einem Substrat/Bondpad, eine Prüfkraft an den Draht bzw. die Bondverbindung angelegt wird. Die Erfindung betrifft weiterhin eine Vorrichtung zum Herstellen einer Drahtbondverbindung zwischen einem Draht und einem Substrat mittels eines Bondwedges, mit der eine Prüfung der hergestellten Drahtbondverbindung möglich ist.

Im Stand der Technik sind unterschiedliche Verfahren zur Prüfung der Qualität einer Drahtbondverbindung bekannt. Beispielsweise wird mittels einer in Längsrichtung an den Draht angelegten Kraft die Bondverbindung derart beansprucht, dass diese aufbricht und zerstört wird. Hierbei wird die Kraft ermittelt, die zur Zerstörung der Bondverbindung nötig war. Zwar liefert ein solches Verfahren eine grundsätzliche Information über die Qualität von Bondverbindungen, bei Anwendung der Prüfung wird jedoch die Bondverbindung selbst zerstört, was einen Nachteil dieser Prüfung darstellt. Ebenso ist es möglich nicht zerstörende Zugprüfungen durchzuführen, bei denen eine derart hohe Kraft in Längsrichtung des Drahtes angelegt wird, dass bei einwandfreien Bondverbindungen die Verbindung der Kraft standhält und lediglich bei qualitativ geringwertigen Bondverbindungen die Verbindung zerstört wird. So können die qualitativ einwandfreien getesteten Verbindungen nach dem Test weiter verwendet werden.

Die im Stand der Technik bekannten Verfahren und Vorrichtungen zur Durchführung einer Qualitätsprüfung von Bondverbindungen haben den Nachteil, dass zum Aufwenden der Prüfkraft eine entsprechende Einrichtung an dem Bondkopf vorgesehen sein muss. So ist es beispielsweise bekannt eine Drahtklemme am Bondkopf anzuordnen, mit der der Draht zwischen zwei Klemmbacken einklemmbar ist, um so durch ein Ziehen am Draht mittels der Klemme eine Kraft auf die Bondverbindung auszuüben. Neben der aufwendigeren Konstruktion benötigt darüber hinaus der gesamte Bondvorgang mit einer anschließenden Prüfung eine insgesamt wesentlich verlängerte Zeit. Aus DE 3717856 A1 ist ein Verfahren zur Montage von Halbleitergeräten und eine Einrichtung zu dessen Durchführung bekannt, wobei mittels eines von dem Bondwerkzeug gesonderten Hilfsmittels eine Prüfkraft an den Bonddraht anlegbar ist. Aus US 6,564,115 B1 ist eine Bondvorrichtung bekannt, die zur Durchführung eines Pull-Tests ebenfalls ein gesondertes, insbesondere mit Bezug auf Figur 6 beschriebenes Testwerkzeug aufweist. Aus US 5,894,981 ist eine Bondvorrichtung bekannt, die zur Durchführung einer Zugprüfung des gebondeten Drahtes mit Klemmbacken oder einer auf den Draht einwirkenden rotatorischen Bremse, d.h. ebenfalls mit gesonderten Prüfwerkzeugen, ausgestattet ist.

Aufgabe der Erfindung ist es ein Verfahren und eine Vorrichtung bereitzustellen, mit der ohne einen größeren konstruktiven Aufwand Bondverbindungen auf ihre Qualität hin geprüft werden können, insbesondere, wobei das Verfahren innerhalb kürzester Zeit durchgeführt werden kann.

Diese Aufgabe wird durch ein Verfahren nach Anspruch 1 und eine Vorrichtung nach Anspruch 8 gelöst, wobei die Prüfkraft, die an den Draht angelegt wird, durch die Spitze des Bondwedges aufgebracht wird.

Gegenüber dem Stand der Technik hat dies den besonderen Vorteil, dass keine zusätzliche Konstruktion, wie beispielsweise eine Drahtklemme am Bondkopf vorgesehen sein muss und dass eine Schädigung der Bondverbindung während des Tests insbesondere durch Abschälen vermieden bzw. ausgeschlossen ist.

Die Prüfkraft, die insbesondere direkt am Ort der Bondverbindung aufgebracht wird, ist bei der erfindungsgemäßen Vorrichtung quer zur Drahtrichtung an den Draht/die Bondverbindung anlegbar, was insbesondere durch eine Relativbewegung zwischen der Aufnahme (dem Transducer) des Ultraschallwerkzeugs und dem befestigten Draht bzw. dem Substrat erfolgen kann.

Auf diese Art und Weise ist es möglich in den eigentlichen Bondvorgang zusätzlich zur Prüfung der Qualität einen Schertest, insbesondere einen nicht zerstörenden Schertest, zu integrieren. Zu diesem Zweck wird die Bondverbindung mit einer derart gewählten Prüfkraft, bei der erfindungsgemäßen Vorrichtung mit einer Querkraft (Scherkraft), belastet, so dass bei einer einwandfreien Bondverbindung die Bondverbindung der Prüfkraft standhält.

Hierdurch wird vermieden, dass einwandfreie Bondverbindungen während des Prüfvorganges aufbrechen und zerstört werden. Lediglich ohnehin qualitativ nicht einwandfreie Bondverbindungen werden bei der entsprechend gewählten Kraft zerstört und können nicht weiter verwendet werden. Besonders vorteilhaft an diesem Verfahren bzw. der dafür vorgesehenen Vorrichtung zum Herstellen einer Drahtbondverbindung zwischen einem Draht und einem Substrat mittels eines Ultraschallwerkzeuges ist es, dass die Prüfkraft nunmehr vom Ultraschallwerkzeug selbst, d.h. beim sogenannten Wedgebonden von der Spitze des Bondwedges aufgebracht wird.

Hierfür kann beispielsweise nach der Herstellung einer Drahtbondverbindung das Wedge vom Draht abgehoben und neben dem Draht platziert werden, so dass dann z.B. durch eine Seitwärtsbewegung der Aufhängung (Transducer) des Ultraschallwerkzeuges quer zur Drahtlängsrichtung von dem Ultraschallwerkzeug/Wedge die Kraft auf den Draht ausgeübt wird. Sofern die Bondverbindung dieser Kraft standhält, wird sie als qualitativ einwandfrei eingestuft. In diesem Fall wird das Ultraschallwerkzeug ähnlich einem Scherkeil eingesetzt.

In einer besonders vorteilhaften Ausführung kann es vorgesehen sein, dass die Prüfkraft an den Draht angelegt wird, während die Nut in der Spitze des Ultraschallwerkzeuges den Draht und/oder die Bondverbindung übergreift. Dies hat den besonderen Vorteil, dass nach der Herstellung der Bondverbindung das Ultraschallwerkzeug nicht erst von der Bondverbindung abgehoben und neben dieser erneut platziert werden muss. Auch existiert direkt nach dem Herstellen der Bondverbindung ein optimaler Formschluß zwischen Ultraschallwerkzeug und dem Draht bzw. der Bondverbindung. Es kann direkt eine Kraft orthogonal zur Bondrichtung in der Bondebene zur Überprüfung der Bondverbindung angelegt werden. Hierbei werden keine Beschädigungen am Draht bzw. der Bondverbindung erzeugt. Die Kraft wird hier mit dem Ultraschallwerkzeug über die seitlichen Wandbereiche der Nut in der Spitze des Ultraschallwerkzeuges aufgebracht.

Hierbei ist gegebenenfalls zu berücksichtigen, dass eine vorbestimmte senkrechte Haltekraft, die sich in Richtung des Ultraschallwerkzeuges erstreckt, aufgebracht wird, da sich durch die Winkel von z.B. 70 Grad zwischen den beiden Wandbereichen einer V-förmigen Nut beim Aufbringen einer Querkraft quer zur Drahtrichtung eine Kraftkomponente in Richtung des Ultraschallwerkzeuges ergibt, die durch eine entsprechend entgegengerichtete Haltekraft kompensiert werden muss, um ein Abrutschen des Ultraschallwerkzeuges vom Draht bei der Prüfung zu verhindern.

Der besondere Vorteil dieser Prüfmethode gegenüber dem Stand der Technik ist es, dass der konstruktive Aufwand deutlich verringert ist, da hierbei wie erwähnt das Ultraschallwerkzeug als Prüfelement dient und eine zusätzliche Drahtklammer, wie sie im Stand der Technik bekannt ist, nicht benötigt wird. Auch ist die Prüfzeit zur Durchführung des erfindungsgemäßen Prüfverfahrens deutlich geringer, da auf eine besondere Ansteuerung eines entsprechenden Prüfelementes, wie z.B. der genannten Klammer, verzichtet werden kann.

Erhebliche Prüfzeiten ergaben sich im Stand der Technik beispielsweise dadurch, dass die Klammer über dem Draht geschlossen wird, anschließend gezogen wird, der Draht wiederum entlastet und dann die Klammer geöffnet wird. Diese Aktionszyklen entfallen vorliegend, da insbesondere bei der bevorzugten Ausführung das Ultraschallwerkzeug nach der Herstellung der Drahtbondverbindung ohnehin auf dieser Verbindung ruht und lediglich die oben genannte Prüfkraft erzeugt werden muss, was in kürzester Zeit möglich ist.

Beispielsweise kann es vorgesehen sein, dass zum Aufbringen der Prüfkraft die Aufnahme des Werkzeuges (Transducer) und/oder der Bondkopf quer zur Drahtrichtung bewegt wird. Hierdurch ergibt sich, insbesondere bei einer Bewegung quer zur Drahtrichtung, automatisch an der Spitze des Ultraschallwerkzeuges durch die Federsteifigkeit des Ultraschallwerkzeuges eine quer zur Drahtrichtung verlaufende Kraft, die die Bondverbindung belastet und somit zur Prüfung der Qualität eingesetzt werden kann.

Somit ist es dementsprechend möglich die Prüfkraft und/oder Prüfbewegung zu erzeugen und/oder zu detektieren im Bondkopf und/oder in den Bewegungsachsen einer Bondmaschine und/oder der Aufnahme eines Bondgutes.

Da es lediglich auf eine Kraft zwischen der Spitze des Ultraschallwerkzeugs und dem Draht bzw. dem Substrat ankommt, besteht beispielsweise auch die Möglichkeit die Kraft an das Bondgut, also z.B. über einen Tisch, auf dem das Substrat gelagert ist, quer zur Drahtrichtung aufzubringen, wofür z.B. ein entsprechender Aktor vorgesehen sein kann.

Die Qualität einer Bondverbindung kann durch wenigstens einen der folgenden Schritte geprüft werden:
i) Beispielsweise wird eine Prüfkraft vorgegeben und die resultierende Bewegung des Ultraschallwerkzeuges ermittelt und ausgewertet. Bewegt sich das Ultraschallwerkzeug aufgrund der angelegten Kraft, so ist die Bondverbindung aufgebrochen und zerstört.
ii) Alternativ oder in Kombination kann es vorgesehen sein, eine Prüfkraft vorzugeben und die Reaktionskraft zu ermitteln und auszuwerten.
iii) Ebenso ist es möglich in einer alternativen oder weiterbildenden Ausgestaltung eine Bewegung der Aufnahme des Ultraschallwerkzeuges vorzugeben und die Reaktionskraft zu ermitteln und auszuwerten.
iv) Es kann auch eine Bewegung des Ultraschallwerkzeuges vorgegeben und eine Verformung des Drahtes und/oder der Bondverbindung und/oder des Ultraschallwerkzeuges mittels eines Sensors ermittelt und ausgewertet werden.

Es ist vorgesehen, dass eine erfindungsgemäße Vorrichtung, die neben der Herstellung einer Bondverbindung auch die Qualitätsprüfung zulässt, einen Sensor zur direkten und/oder indirekten Erfassung einer durch das Bondwedge an den Draht/die Bondverbindung angelegten Kraft und insbesondere einen Sensor zur Erfassung der Bewegung des Bondwedges aufweist.

Es kann z.B. am Bondkopf ein Kraftsensor vorgesehen sein, mittels dem die Kraft gemessen wird, die über das Ultraschallwerkzeug auf den Draht aufgebracht wird. Die gemessene Kraft kann als Regelgröße dienen, um z.B. die Achsen der Bondmaschine so zu steuern, dass eine gewünschte Prüfkraft eingestellt wird.

Bricht die Bondstelle bei dieser Kraft auf, so kann dies z.B. über Positionsgeber ermittelt werden. Bei Überschreiten eines vorgegebenen Schwellwertes (der mit dem Positionsgeber gemessen wird) wird auf eine zerstörte Bondstelle geschlossen. Ebenso kann auf eine zerstörte Bondstelle geschlossen werden, wenn eine Soll-Prüfkraft nicht erreicht wird.

Ein Ausführungsbeispiel der Erfindung ist in der nachfolgenden Abbildung näher dargestellt.

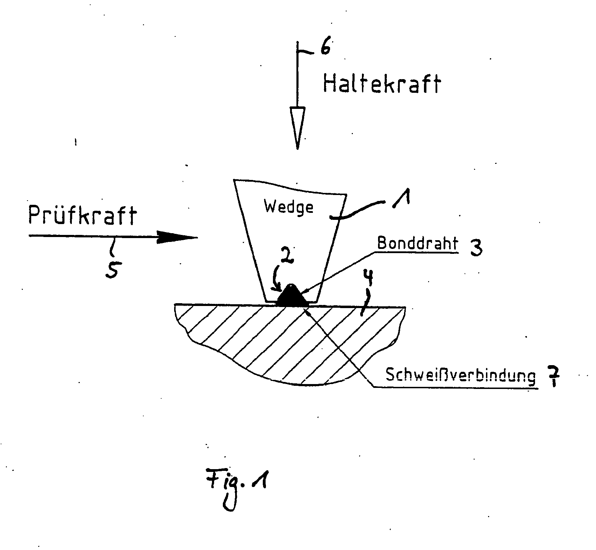

Die einzige Figur 1 zeigt die Lage eines Ultraschallwerkzeuges, hier als Wedge 1 bezeichnet, das mit seiner V-förmigen Nut 2 nach der Herstellung der Drahtbondverbindung auf dem Bonddraht 3 aufliegt. Der bei der Verbindung verformte Bonddraht 3 ist hierbei vollständig von der V-förmigen Nut 2 umschlossen.

Zur Durchführung einer Qualitätsprüfung während der Herstellung einer Bondverbindung zwischen zwei Elektroden/ Bondpads kann dementsprechend direkt nach dem Anbringen des Bonddrahtes mittels einer Reibschweißverbindung auf dem Substrat 4 eine Prüfkraft auf den Bonddraht 3 bzw. die herstellte Drahtbondverbindung aufgebracht werden, die in der hier dargestellten Richtung des Pfeils 5 quer zur Längsachse des Bonddrahtes verläuft.

Aufgrund der in der Figur dargestellten V-förmigen Nut, bei der die seitlichen Wandbereiche hier bevorzugt etwa einen Winkel von 70 Grad zueinander einnehmen, kann es bei dem Anlegen der Prüfkraft zu einer Kraftkomponente in Richtung des Ultraschallwerkzeuges 1 kommen, so dass durch eine dagegen gerichtete Haltekraft in Richtung des Pfeils 6 eine Kompensation erfolgen muss, um ein Abheben des Ultraschallwerkzeuges 1 von der Drahtbondverbindung während der Prüfung zu vermeiden.

Die Erzeugung der Prüfkraft zwischen dem Ultraschallwerkzeug bzw. dessen in der Darstellung abgebildeten Spitze und dem Bonddraht 3 bzw. dem Substrat 4 kann auf verschiedene Arten und Weisen erfolgen. Beispielsweise kann der gesamte Bondkopf in einer entsprechenden Richtung bewegt werden, wobei sich durch die Federsteifigkeit des Ultraschallwerkzeuges die Kraft ergibt.

Alternativ kann durch einen Aktor lediglich eine Auslenkung der Aufnahme des Ultraschallwerkzeuges quer zur Drahtlängsrichtung hervorgerufen werden.

Ebenso kann die Erzeugung der Kraft über das Substrat in der entsprechenden Aufnahme bzw. mittels der entsprechenden Aufnahme gegenüber dem Ultraschallwerkzeug 1 erzeugt werden.

Insgesamt können alle für den Fachmann erdenklichen Maßnahmen vorgesehen sein, um die Kraftwirkung zu erzeugen.

In dem vorliegenden Fall wird die Qualität der Bondverbindung dadurch festgestellt, dass sie beim Anlegen der Prüfkraft dieser standhält. Sollte die Verbindung der Prüfkraft, die entsprechend voreingestellt ist, nicht standhalten, so bricht die Verbindung auf, was zu einer sprunghaften Reduktion der Reaktionskraft oder einer (erhöhten) Auslenkung des Ultraschallwerkzeuges resultiert, wodurch beispielsweise durch entsprechend eingesetzte Sensoreinrichtungen das Aufbrechen der Bondverbindung detektiert werden kann.

## Patentansprüche

1. Verfahren zur insbesondere zerstörungsfreien Prüfung einer Drahtbondverbindung, bei dem nach der Herstellung einer Bondverbindung mittels eines Bondwedges zwischen einem Draht und einem Substrat/ Bondpad eine Prüfkraft an den Draht angelegt wird, **dadurch gekennzeichnet, dass** die Prüfkraft (5) durch die Spitze des Bondwedges (1) aufgebracht wird.

2. Verfahren nach Anspruch 1, **dadurch gekennzeichnet, dass** die Prüfkraft (5), insbesondere am Ort der Bondverbindung (7), quer zur Drahtrichtung an den Draht (3) angelegt wird.

3. Verfahren nach einem der vorherigen Ansprüche, **dadurch gekennzeichnet, dass** die Prüfkraft (5) an den Draht (3) angelegt wird während die Nut (2) in der Spitze des Bondwedges (1) den Draht (3) und/ oder die Bondverbindung (7) übergreift.

4. Verfahren nach einem der vorherigen Ansprüche, **dadurch gekennzeichnet, dass** die Prüfkraft (5) derart gewählt wird, dass bei einer einwandfreien Bondverbindung (7) die Bondverbindung (7) der Prüfkraft (5) standhält.

5. Verfahren nach einem der vorherigen Ansprüche, **dadurch gekennzeichnet, dass** zum Aufbringen der Prüfkraft (5) das Bondwedge (1) und/ oder der Bondkopf quer zur Drahtrichtung bewegt wird.

6. Verfahren nach einem der vorherigen Ansprüche, **dadurch gekennzeichnet, dass** die Qualität einer Bondverbindung (7) durch wenigstens einen der folgenden Schritte geprüft wird:
i. Es wird eine Prüfkraft (5) vorgegeben und die resultierende Bewegung des Bondwedges (1) ermittelt und ausgewertet;
ii. Es wird eine Bewegung der Aufnahme des Bondwedges (1) vorgegeben und die Reaktionskraft ermittelt und ausgewertet;
iii. Es wird eine Bewegung der Aufnahme des Bondwedges (1) vorgegeben und eine Verformung des Drahtes (3) und/ oder Bondverbindung (7) und/ oder des Bondwedges (1) und/ oder eines Sensors ermittelt und ausgewertet.

7. Verfahren nach einem der vorherigen Ansprüche, **dadurch gekennzeichnet, dass** die Prüfkraft (5) und/oder Prüfbewegung erzeugt und/oder detektiert wird im Bondkopf und/oder in den Bewegungsachsen einer Bondmaschine und/oder der Aufnahme eines Bondgutes.

8. Vorrichtung zum Herstellen einer Drahtbondverbindung zwischen einem Draht und einem Substrat mittels eines Bondwedges **dadurch gekennzeichnet, dass** mittels des Bondwedges (1) eine Prüfkraft (5) an den Draht (3)/die Bondverbindung (7) anlegbar ist, wobei die Prüfkraft (5) quer zur Drahtrichtung in der Bondebene ausgerichtet ist, und dass die Vorrichtung einen Sensor zur direkten und/ oder indirekten Erfassung einer durch das Bondwedge (1) an den Draht (3)/ die Bondverbindung (7) angelegten Kraft aufweist.

9. Vorrichtung nach Anspruch 8, **dadurch gekennzeichnet, dass** zum Prüfen der Qualität einer Bondverbindung (7) zwischen der Aufnahme des Bondwedges (1) und dem Draht (3) / der Bondverbindung (7) eine Relativbewegung erzeugbar ist.

10. Vorrichtung nach einem der vorherigen Ansprüche, **dadurch gekennzeichnet, dass** sie einen Sensor zur Erfassung der Bewegung der Aufnahme des Bondwedges (1) aufweist.

## Claims

1. Method for, in particular, destruction-proof testing of a wire bonding connection, in which, after a bonding connection has been produced between a wire and a substrate/bonding pad by a bonding wedge, a testing force is applied to the wire, **characterised in that** the testing force (5) is exerted through the tip of the bonding wedge (1).

2. Method according to claim 1, **characterised in that** the testing force (5) is applied to the wire (3) transversely to the direction of the wire, in particular at the location of the bonding connection (7).

3. Method according to one of the previous claims, **characterised in that** the testing force (5) is applied to the wire (3) while the groove (2) in the tip of the bonding wedge (1) overlaps the wire (3) and/or the bonding connection (7).

4. Method according to one of the previous claims, **characterised in that** the testing force (5) is chosen in such a way that if there is a perfect bonding connection (7) the bonding connection (7) withstands the testing force (5).

5. Method according to one of the previous claims, **characterised in that** to exert the testing force (5) the bonding wedge (1) and/or the bonding head is/are moved transversely to the direction of the wire.

6. Method according to one of the previous claims, **characterised in that** the quality of a bonding connection (7) is tested by at least one of the following steps:
i. a testing force (5) is preset and the resulting movement of the bonding wedge (1) is determined and evaluated;
ii. a movement of the retainer of the bonding wedge (1) is preset and the power of reaction is determined and evaluated;
iii. a movement of the retainer of the bonding wedge (1) is preset and a deformation of the wire (3) and/or the bonding connection (7) and/or the bonding wedge (1) and/or a sensor is determined and evaluated.

7. Method according to one of the previous claims, **characterised in that** the testing force (5) and/or testing movement is/are generated and/or detected in the bonding head and/or in the movement axes of a bonding machine and/or the retainer of a bonded article.

8. Device for producing a wire bonding connection between a wire and a substrate by means of a bonding wedge, **characterised in that** by means of the bonding wedge (1) a testing force (5) can be applied to the wire (3)/the bonding connection (7), wherein the testing force (5) is aligned transversely to the direction of the wire in the bonding plan and **in that** the device has a sensor for direct and/or indirect detection of a force applied to the wire (3)/the bonding connection (7) through the bonding wedge (1).

9. Device according to claim 8, **characterised in that** a relative movement between the retainer of the bonding wedge (1) and the wire (3)/the bonding connection (7) can be generated to test the quality of a bonding connection (7).

10. Device according to one of the previous claims, **characterised in that** it has a sensor for detecting the movement of the retainer of the bonding wedge (1).

## Revendications

1. Procédé pour le contrôle, en particulier non destructif, d'une connexion fixe ou soudée de fil lors duquel après réalisation d'une connexion fixe ou par soudage entre un fil et un substrat/plot de soudage, au moyen d'un coin de soudage, une force de contrôle ou de test est appliquée sur le fil, **caractérisé en ce que** la force de test (5) est exercée par la pointe du coin de soudage (1).

2. Procédé selon la revendication 1, **caractérisé en ce que** la force de test (5) est appliquée sur le fil (3), transversalement au sens du fil, en particulier à l'emplacement de la connexion soudée (7).

3. Procédé selon l'une des revendications précédentes, **caractérisé en ce que** la force de test (5) est appliquée sur le fil (3) tandis que la rainure (2) dans la pointe du coin de soudage (1) recouvre le fil (3) et/ou la connexion soudée (7).

4. Procédé selon l'une des revendications précédentes, **caractérisé en ce que** la force de test (5) est choisie de telle sorte qu'avec une connexion soudée (7) correcte, la connexion soudée (7) supporte la force de test (5).

5. Procédé selon l'une des revendications précédentes, **caractérisé en ce que** pour appliquer la force de test (5), le coin de soudage (1) et/ou la tête de soudage est déplacé transversalement au sens du fil.

6. Procédé selon l'une des revendications précédentes, **caractérisé en ce que** la qualité d'une connexion soudée (7) est vérifiée par au moins l'une des étapes suivantes:
i) on prédéfinit une force de test (5) puis on détermine et analyse le mouvement du coin de soudage (1) qui en résulte;
ii) on prédéfinit un mouvement du logement du coin de soudage (1) puis on détermine et analyse la force de réaction;
iii) on prédéfinit un mouvement du logement du coin de soudage (1) et on détermine et analyse une déformation du fil (3) et / ou de la connexion soudée (7) et/ou du coin de soudage (1) et / ou d'un capteur.

7. Procédé selon l'une des revendications précédentes, **caractérisé en ce que** la force de test (5) et / ou le mouvement de test est généré et / ou détecté dans la tête de soudage et / ou dans les axes de déplacement d'une machine de soudage et/ou du logement d'une matière d'apport de soudage.

8. Dispositif de réalisation d'une connexion soudée ou d'une liaison fixe entre un fil et un substrat au moyen d'un coin de soudage (1) **caractérisé en ce qu'**une force de test (5) est applicable sur le fil (3) / la connexion soudée (7) au moyen du coin de soudage (1), la force de test (5) étant dirigée transversalement au sens du fil dans le plan de soudage ou de liaison, et **en ce que** le dispositif comporte un capteur pour la détection directe et/ou indirecte d'une force appliquée par le coin de soudage (1) au fil (3) / à la connexion soudée (7).

9. Dispositif selon la revendication 8, **caractérisé en ce que** pour tester la qualité d'une connexion soudée (7), un mouvement relatif est susceptible d'être généré entre le logement du coin de soudage (1) et le fil (3) / la connexion soudée (7).

10. Dispositif selon l'un quelconque des revendications précédentes, **caractérisé en ce qu'**il comporte un capteur pour la détection du mouvement du logement du coin de soudage (1).
